(19) Europäisches Patentamt
European Patent Office
Office européen des brevets

(11) EP 2 499 741 B1

(12) **EUROPEAN PATENT SPECIFICATION**

(45) Date of publication and mention
of the grant of the patent:
**31.08.2016 Bulletin 2016/35**

(51) Int Cl.:
***H03K 5/159*** (2006.01)

(21) Application number: **10781483.2**

(86) International application number:
**PCT/EP2010/067400**

(22) Date of filing: **12.11.2010**

(87) International publication number:
**WO 2011/058142 (19.05.2011 Gazette 2011/20)**

(54) **TIME-TO-DIGITAL CONVERTER WITH SUCCESSIVE MEASUREMENTS**

ZEIT-DIGITAL-WANDLER MIT SUKZESSIVEN MESSUNGEN

CONVERTISSEUR TEMPS-NUMÉRIQUE AVEC MESURES SUCCESSIVES

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **13.11.2009 FR 0958016**

(43) Date of publication of application:
**19.09.2012 Bulletin 2012/38**

(73) Proprietor: **ST-Ericsson SA**
**1228 Plan-les-Ouates (CH)**

(72) Inventor: **RIEUBON, Sébastien**
**F-38430 St Jean de Moirans (FR)**

(74) Representative: **Cabinet Plasseraud**
**66, rue de la Chaussée d'Antin**
**75440 Paris Cedex 09 (FR)**

(56) References cited:
| EP-A1- 1 160 976 | US-A- 4 620 180 |
|---|---|
| US-A- 5 229 668 | US-A- 5 420 531 |
| US-A- 6 108 794 | US-A1- 2004 135 606 |
| US-A1- 2005 201 455 | US-A1- 2008 012 549 |
| US-A1- 2009 028 274 | |

## Description

The invention relates to the conversion into digital information of the frequency difference between a first signal and a second signal or reference signal. More specifically, it concerns the measurement of the fractional part of the number of cycles or periods of a first signal within a period of a reference signal.

Many electronic devices, such as mobile telephones or computers, make use of at least one cyclic digital signal generator. This digital signal generally consists of square pulses. It is often useful to measure the pulse frequency, for example in order to monitor the frequency of the digital signal relative to a target value so that modifications can be made to bring the value closer to said target value.

To do this, a first step can consist of measuring the number of pulses in the digital signal, contained within a period of a reference signal of a known frequency.

To improve the accuracy, it is then desirable to measure the fractional part of this number over the same period of the reference signal.

The document US 2008/012549 discloses a built-in self-test (BIST) circuit and an associated method for measuring phase and/or cycle-to-cycle jitter of a clock signal.

The document US 5,229,668 discloses that a data signal may be sampled at high speed using a clock signal by propagating the data signal and the clock signal through a series of data and clock delay elements, respectively, and latching the corresponding delayed data and clock signals.

The document US 2009/028274 discloses a time to digital converter having a hierarchical structure.

The document US 6,108,794 discloses a signal comparison system that determines whether a data signal is transitioning close to transitions of its clock signal, thereby causing possible errors in the sampling of the data signal.

A need therefore exists for a means for measuring this fractional part, one which consumes little energy and only marginally affects the spectrum of the digital signal measured, while providing sufficient functional accuracy for the anticipated applications.

A first aspect of the invention proposes a time-to-digital conversion process for determining a digital information item corresponding to a fractional part of the number of periods of a first signal contained within a period of a second signal. It comprises the following steps:

/1/ delaying the second signal relative to the first signal,

/2/ determining a first digital information item, a function of the fractional part,

/3/ delaying the first signal relative to the second signal,

/4/ determining a second digital information item, a function of the fractional part,

/5/ calculating the digital information item corresponding to the fractional part as a function of the first and second digital information items obtained during steps /2/ and /4/;

the second signal being delayed by a first timer delay and the first signal being delayed by a second timer delay, with first timer delay being greater than second timer delay;

steps /1/, /2/, /3/, /4/ being repeated at least once, before step /5/, with first timer delay being less than second timer delay.

In parallel, the process allows multiplying the measurements used to calculate the fractional part. However, for a same period of the second signal, increasing the time shift between the second signal and the first signal allows improving the accuracy of the measurement of the fractional part, particularly because this enables determining a larger number of digital information items, functions of the fractional part.

A second aspect proposes a computer program comprising instructions for implementing the process according to the first aspect when said program is executed by a processor.

A third aspect proposes a time-to-digital conversion device comprising first connection means for receiving a first signal and a second signal, as well as an output for delivering a fractional part of the number of periods of the first signal contained within a period of the second signal. It additionally comprises timing and comparison means adapted to implement the following processing:

/a/ delaying the second signal relative to the first signal,

/b/ measuring a first digital information item, a function of the fractional part,

/c/ delaying the first signal relative to the second signal,

/d/ measuring a second digital information item, a function of the fractional part;

the processing sequence /a/, /b/, /c/ and /d/ being repeated at least once;

said device further comprising a first vernier delay unit comprising a first delay line and a second delay line, a timer delay introduced by the first delay line being greater than a timer delay introduced by the second delay line and a second vernier delay unit comprising a second vernier delay line comprising a first delay line and a second delay line, a timer delay introduced by the first delay line being less than a timer delay introduced by the second delay line; the first vernier delay unit and second vernier unit being serially connected.

The device comprises a calculation means coupled to the timing and comparison means in order to determine the digital information item corresponding to the fractional part, based on the first and second digital information items.

In particular, the timing and comparison means can be adapted to repeat the processing sequence /a/, /b/, /c/ and /d/ at least once.

By alternatively delaying the second signal and the first signal relative to each other, the device limits the spikes in power consumption. In addition, the accuracy of the calculation of the fractional part depends on the accuracy with which it is possible to know the value of the shift actually introduced between the signals. The time shift is typically created by a series of clocks implemented by a plurality of transistor-based delay circuits. The time shift can be increased by increasing the duration of the time delay individually introduced by each delay circuit. The benefits obtained by means of this last possibility are offset, however, by the decreased accuracy for the duration of each time delay introduced. Increasing the time shift can also be achieved by increasing the number of delay circuits. However, the greater the number of circuits, the more the power consumption increases for a same measured reference period. The increase in power consumption is also accompanied by spectral disturbances (particularly spurious lines in the high and low frequencies). In particular, the device allows increasing the number of measurements when the delay circuits have equal time delays.

In the device according to the third aspect, in order to satisfy other needs, the timing and comparison means can comprise at least one vernier delay unit receiving the second signal and the first signal. Each vernier delay unit then comprises:

- a first delay line, coupled to the first connection means in order to receive the second signal or the first signal, comprising a first whole number of timers each of which delays a signal passing through it by a first duration,
- a second delay line, coupled to the first connection means in order to receive the second signal or the first signal, comprising the same first whole number of timers each of which delays a signal passing through it by a second duration,
- a sampling unit comprising latches adapted to sample the first signal in order to obtain a digital information item which is a function of the fractional part.

In particular, the device according to the third aspect may comprise timing and comparison means comprising at least two serially connected vernier delay units.

Alternatively, the device of the third aspect can comprise timing and comparison means which comprise a single vernier delay unit. The device then comprises switching means adapted to alternate between directing, each time for a determined period of the second signal:

- the second signal to the first delay line and the first signal to the second delay line; or

- the second signal to the second delay line and the first signal to the first delay line.

This embodiment reduces the silicon surface area required for the production of the device, because a single vernier delay unit is used.

Alternatively, the device according to the third aspect can comprise timing and comparison means comprising a first vernier delay unit and a second vernier delay unit, serially connected, with the device comprising switching and timing means adapted to direct:

- the second signal, delayed by a third duration, to the first delay line of the first vernier delay unit, and
- the first signal, delayed by a fourth duration, to the second delay line of the first vernier delay unit.

This embodiment limits the meta-unstable states which can adversely impact the accuracy of the calculation of the fractional part.

In a fourth aspect, a digital phase-locked loop (or digital PLL) is proposed, adapted to deliver a first signal of a frequency controlled by a set point signal. The digital PLL comprises a time-to-digital conversion device according to the third aspect, in order to determine a fraction of the number of cycles of the first signal contained within a period of a second signal.

A fifth aspect proposes a portable electronic device comprising a digital phase-locked loop according to the fourth aspect.

Other features and advantages of the invention will become apparent upon reading the following description. This description is purely illustrative and is to be read with reference to the attached drawings, in which:

- figure 1 is a schematic diagram of a vernier delay unit according to one embodiment,
- figure 2 is a timing diagram representing the main signals passing through the vernier delay unit during operation,
- figure 3 is a schematic diagram of a first embodiment of a time-to-digital converter,
- figure 4 is a schematic diagram of a second embodiment of a time-to-digital converter,
- figure 5 is a schematic diagram of a third embodiment of a time-to-digital converter,
- figure 6 is a schematic diagram of a digital phase-locked loop comprising a time-to-digital converter,
- figure 7 is a schematic diagram of a radio communication transmitter/receiver according to one embodiment,
- figure 8 is a process diagram of the time-to-digital conversion according to one embodiment.

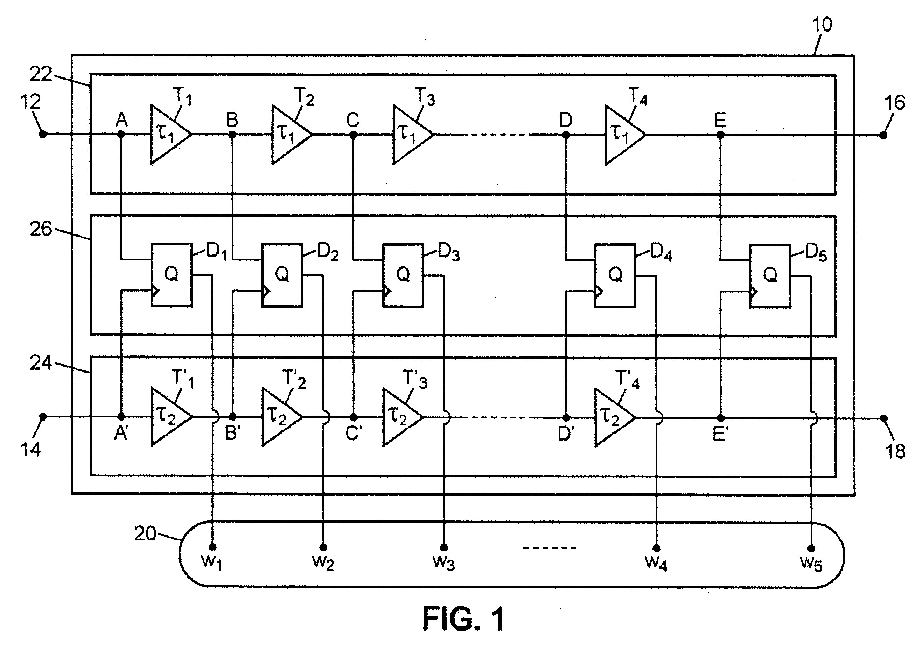

In the following sections, a vernier delay unit 10 as represented in figure 1 is examined for purely illustrative purposes. The vernier delay unit 10 comprises a first input 12 for receiving a first digital signal $S_1$ of frequency

$F_1$. The vernier delay unit 10 comprises a second input 14 for receiving a second digital signal $S_2$ of frequency $F_2$. The vernier delay unit 10 comprises a first output 16 for delivering a third signal $S_3$, a second output 18 for delivering a fourth signal $S_4$, and a third output 20 for delivering a digital word W. The vernier delay unit 10 comprises a first delay line 22 and a second delay line 24. The first delay line 22 comprises a whole number N of timers T, each of which allows delaying the first signal $S_1$ by a duration $\tau_1$. The second delay line 24 comprises the same whole number N of timers $T_2$, each of which allows delaying the second signal $S_2$ by a duration $\tau_2$. For clarity in the example in figure 1, the points A, B, C, D and E are represented on the first delay line 22. Point A corresponds to the first input 12 while point E corresponds to the first output 16. A first timer $T_1$ is arranged between point A and point B, a second timer $T_2$ between point B and point C, a third timer $T_3$ between point C and point D, and a fourth timer $T_4$ between point D and point E. Similarly, points A', B', C', D' and E' are represented on the second delay line 24. Point A' corresponds to the second input 14 while point E' corresponds to the second output 18. A first timer $T'_1$ is arranged between point A' and point B', a second timer $T'_2$ between point B' and point C', a third timer $T'_3$ between point C' and point D', and a fourth timer $T'_4$ between point D' and point E'.

The vernier delay unit 10 comprises a sampling unit 26 comprising latches D. Each latch D is adapted to receive the first signal $S_1$ on a first input and the second signal $S_2$ on a second input, and to deliver on an output Q the binary value of the first signal $S_1$ after a rising edge has been detected in the second signal $S_2$. Each latch D therefore allows sampling the first signal $S_1$ by the second signal $S_2$. In the sampling unit 26, the latches D are arranged so that a binary value w is obtained on the output Q before and after each new timer delay simultaneously introduced in the first signal $S_1$ and the second signal $S_2$. In the example in figure 1, the sampling unit 26 comprises:

- a first latch $D_1$, which delivers a binary value $w_1$ on its output Q, and for which the first input is connected to point A and the second input is connected to point A',
- a second latch $D_2$, which delivers a binary value $w_2$ on its output Q, and for which the first input is connected to point B and the second input is connected to point B',
- a third latch $D_3$, which delivers a binary value $w_3$ on its output Q, and for which the first input is connected to point C and the second input is connected to point C',
- a fourth latch $D_4$, which delivers a binary value $w_4$ on its output Q, and for which the first input is connected to point D and the second input is connected to point D',
- a fifth latch $D_5$, which delivers a binary value $w_5$ on its output Q, and for which the first input is connected to point E and the second input is connected to point E'.

The sampling unit 26 comprises N+1 latches D. The word W, delivered by the sampling unit 26 on the third output 20, is thus equal to the word formed by the sequence of binary values from each output Q of the latches D. In the example in figure 1, the five-bit word W is equal to $w_1 w_2 w_3 w_4 w_5$.

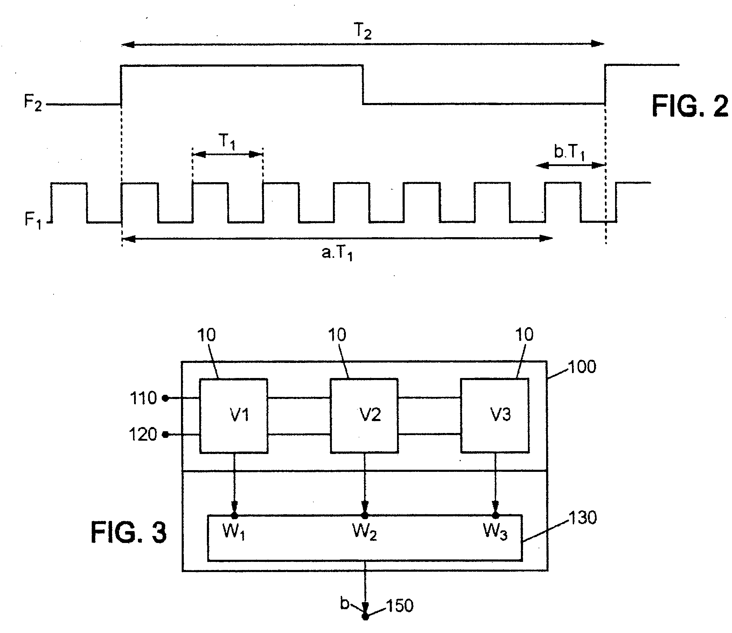

Figure 2 represents a timing diagram in which the first signal $S_1$ of period $T_1 = \dfrac{1}{F_1}$ and the second signal $S_2$ of period $T_2 = \dfrac{1}{F_2}$ are represented. Note in particular that the period $T_1$ can be expressed as $T_2 = T_1 \times (a + b)$, where a is an integer and b is a real number strictly between 0 and 1. The period $T_2$ can therefore be expressed as a multiple of the period $T_1$ to which is added a fraction of the period $T_1$.

During operation, the sampling unit 26 receives the first signal $S_1$ and the second signal $S_2$, and delivers:

- on the first output 16, the first signal $S_1$ delayed by $N \times \tau_1$,
- on the second output 18, the second signal $S_2$ delayed by $N \times \tau_2$,
- on the third output 20, the corresponding word W.

Figure 3 illustrates a first embodiment of a time-to-digital converter 100. The converter 100 comprises:

- a first connection means 110 for receiving an output signal $S_{out}$ of frequency $F_{out}$,
- a second connection means 120 for receiving a reference signal $S_{ref}$ of frequency $F_{ref}$,
- at least two vernier delay units 10, forming a chain of serially connected vernier delay units 10,
- a calculation means 130 connected to the output 20 of each vernier delay unit 10,
- an output 150 for delivering the fractional part of the number of periods of the output signal $S_{out}$ per period of the reference signal $S_{ref}$.

In the example in figure 3, the converter 100 comprises three serially connected vernier delay units, respectively denoted as V1, V2, and V3, delivering the words W1, W2, W3. The first input 12 to the vernier delay unit V1 is connected to the first connection means 110 of the converter 100. The second input 14 to the vernier delay unit V1 is connected to the second connection means 120 of the converter 100. Each vernier delay unit not located at an end of the chain, V2 in the example in figure 3, has its first output connected to the first input of the next vernier delay unit in the chain and its second output connected to the second input of the next vernier delay unit in the chain. Thus, the output signal $S_{out}$ and the reference signal $S_{ref}$ traverse the chain of vernier delay units. In the particular case illustrated in figure 3, each vernier delay unit of the chain comprises the same number N of timers T and latches D. The chain is arranged to comprise in succession:

- a vernier delay unit for which the timer delay $\tau_1$ introduced by the first delay line 22 is greater than the timer delay $\tau_2$ introduced by the second delay line 24; then

- a vernier delay unit for which the timer delay $\tau_1$ introduced by the first delay line 22 is less than the timer delay $\tau_2$ introduced by the second delay line 24.

Thus, in the example in figure 3, if $\tau_1^{V1}$, $\tau_1^{V2}$, $\tau_1^{V3}$ denote the respective timer delays $\tau_1$ introduced by the first delay line 22 of vernier delay units V1, V2, V3, and $\tau_2^{V1}$, $\tau_2^{V2}$, $\tau_2^{V3}$ denote the respective timer delays $\tau_2$ introduced by the second delay line 24 of vernier delay units V1, V2, V3, one can write the following mathematical relations:

$$\tau_2^{V1} > \tau_1^{V1}, \ \tau_2^{V2} < \tau_1^{V2}, \ \tau_2^{V3} > \tau_1^{V3}.$$

The vernier delay units of the chain will therefore alternate between delaying the reference signal $S_{ref}$ relative to the output signal $S_{out}$, and delaying the output signal $S_{out}$ relative to the reference signal $S_{ref}$. In one embodiment, the timer delays $\tau_1$ and $\tau_2$ are selected such that $\tau_1^{V1} = \tau_2^{V2} = \tau_1^{V3}$ and $\tau_2^{V1} = \tau_1^{V2} = \tau_2^{V3}$.

Alternatively, each vernier delay unit in the chain can comprise a different number N of timers T and latches D. The chain is then arranged such that, when considering pairs of two immediately adjacent vernier delay units, the signal propagation time in one of the vernier delay units of each pairing compensates for the propagation time introduced by the other vernier delay unit in the group. Considering, for example, the pairing which consists of the vernier delay unit V1 equipped with a number $N_{V1}$ of timers T and the vernier delay unit V2 equipped with a number $N_{V2}$, of timers T, the following mathematical expression is then satisfied:

$$N_{V1} \cdot (\tau_1^{V1} - \tau_2^{V1}) = N_{V2} \cdot (\tau_2^{V2} - \tau_1^{V2})$$

The calculation means 130, connected to the third output 20 of each vernier delay unit, are adapted to calculate the fractional part of the number of periods of the output signal $S_{out}$ per period of the reference signal $S_{ref}$, based on the words W. In particular, this fractional part can be obtained by calculating the mean of the values of the fractional part b corresponding to each word W. Alternatively, this fractional part can also be obtained by applying Gaussian filtering to the different values obtained for the fractional part b. In the special case where $\tau_1^{V1} = \tau_1^{V2} = \tau_1^{V3}$ and $\tau_2^{V1} = \tau_2^{V2} = \tau_2^{V3}$, the value of the fractional part b obtained from the words W1, W2 and W3 is identical, aside from small inaccuracies due primarily to the meta-unstable states of the vernier delay unit latches as well as to the unpairing of the delays.

For vernier delay units which have an uneven number for their sequential position in the chain (in the example in figure 3, this corresponds to vernier delay units V1 and V3), the fractional part b can be obtained from the word W by applying the relation $b = \dfrac{D_d}{D_{out}}$, where:

- $D_d$ is the number of consecutive bits equal to 0 at the start of the binary sequence forming the word W,
- $D_{out}$ is the number of bits forming the sequence(s) "1*0*" in the word W (in the present description, the notation "1*0*" is a regular extended expression ERE).

For vernier delay units which have an even number for their sequential position in the chain (in the example in figure 3, this corresponds to the vernier delay unit V2), the fractional part b can be obtained from the word W by applying the following relation $b = \dfrac{D_d}{D_{out}}$, where:

- $D_d$ is the number of consecutive bits equal to 0 at the end of the binary sequence forming the word W,
- $D_{out}$ is the number of bits forming the sequence(s) "0*1*" in the word W (in the present description, the notation "0*1*" is a regular extended expression ERE).

As a non-limiting example, if N is equal to 12 and if the words W1, W2, W3 are respectively equal to 001110000111, 111000111100, and 001111000111, we then obtain:

- for W1, $D_d$=2, $D_{out} = 7$, $b = \dfrac{2}{7}$

- for W2, $D_d$=2, $D_{out} = 7$, $b = \dfrac{2}{7}$

- for W3, $D_d$=2, $D_{out} = 7$, $b = \dfrac{2}{7}$.

In this example, on the average, the fractional part b is equal to $\frac{2}{7}$.

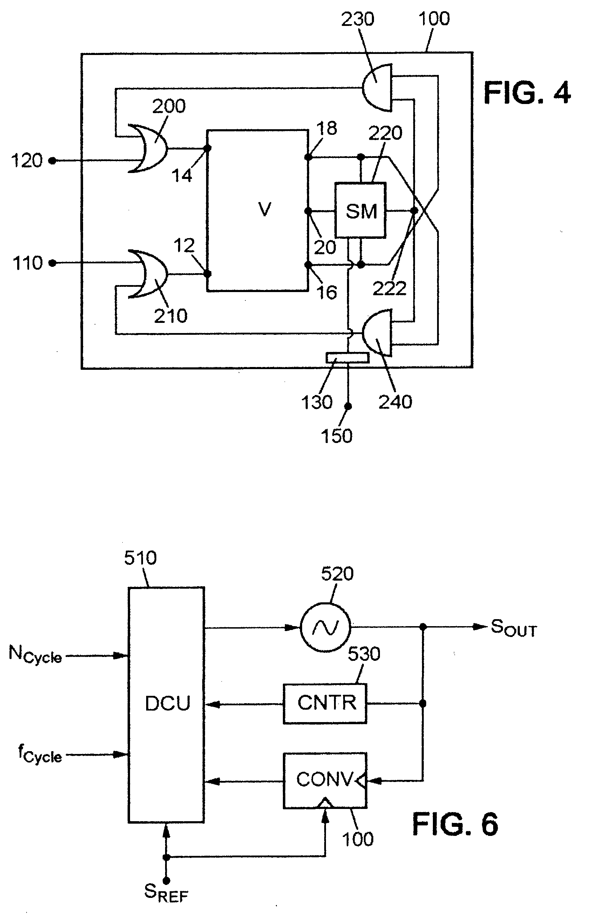

In the example in figure 4, the converter 100 is represented in a first alternative embodiment, comprising a vernier delay unit V, a first "OR" logic gate 200, a second "OR" logic gate 210, a state machine 220, a first "AND" logic gate 230, a second "AND" logic gate 240, and a calculation means 130.

The "OR" logic gates 200 and 210 are each designed to perform a Boolean non-exclusive OR operation on the input signals received in order to obtain an output signal. The "AND" logic gates 230 and 240 are each designed to perform an AND Boolean operation on the input signals received in order to obtain an output signal. The inputs to the first "OR" logic gate 200 are connected to receive the output signal from the first "AND" logic gate 230 and the reference signal $S_{ref}$. The output signal from the first "OR" logic gate 200 is connected to the second input 14 to the vernier delay unit V. The inputs to the second "OR" logic gate 210 are connected to receive the output signal from the second "AND" logic gate 240 and the output signal $S_{out}$. The output signal from the second "OR" logic gate 210 is connected to the first input 12 of the vernier delay unit V.

The state machine 220 comprises an input for receiving the word W delivered by the vernier delay unit V, and inputs for receiving the output signal $S_{out}$ and the reference signal $S_{ref}$ output from the vernier delay unit V. The state machine 220 has the particular function of allowing or not allowing output signals from the vernier delay unit V to loop to the inputs of the vernier delay unit V. To do this, the state machine 220 comprises an output 222 which delivers a control signal. The control signal initially has a value of 0. The state machine 220 is programmed so that the control signal assumes a value of 1 upon detection of the rising or falling edge of the output signal $S_{out}$. Alternatively, the state machine 220 can be programmed so that the control signal assumes a value of 1 upon detection of the rising or falling edge of the output signal from the vernier delay unit V which has been subjected to a timer delay in the vernier delay unit V of the smallest duration. The state machine 220 also has the function of sending to the calculation means 130 the words W successively delivered over time by the vernier delay unit V.

The inputs to the first "AND" logic gate 230 are connected to receive the output signal from the state machine 220 and the output signal $S_{out}$ from the vernier delay unit V. The inputs to the second "AND" logic gate 240 are connected to receive the output signal from the state machine 220 and the reference signal $S_{ref}$ that is output by the vernier delay unit V.

In the first alternative embodiment, the calculation means 130 are adapted to calculate the fractional parts b from a series of received words W delivered by the state machine 220, by applying the relation

$$b = \frac{D_d}{D_{out}} \quad \text{where:}$$

- for the words W which have an odd number for their sequential position in the series of received words W, $D_d$ is the number of consecutive bits equal to 0 at the start of the binary sequence forming the word W, and $D_{out}$ is the number of bits forming the sequence(s) "1*0*" in the word W, and
- for the words W which have an even number for their sequential position in the series of received words W, $D_d$ is the number of consecutive bits equal to 0 at the end of the binary sequence forming the word W, and $D_{out}$ is the number of bits forming the sequence(s) "0*1*" in the word W.

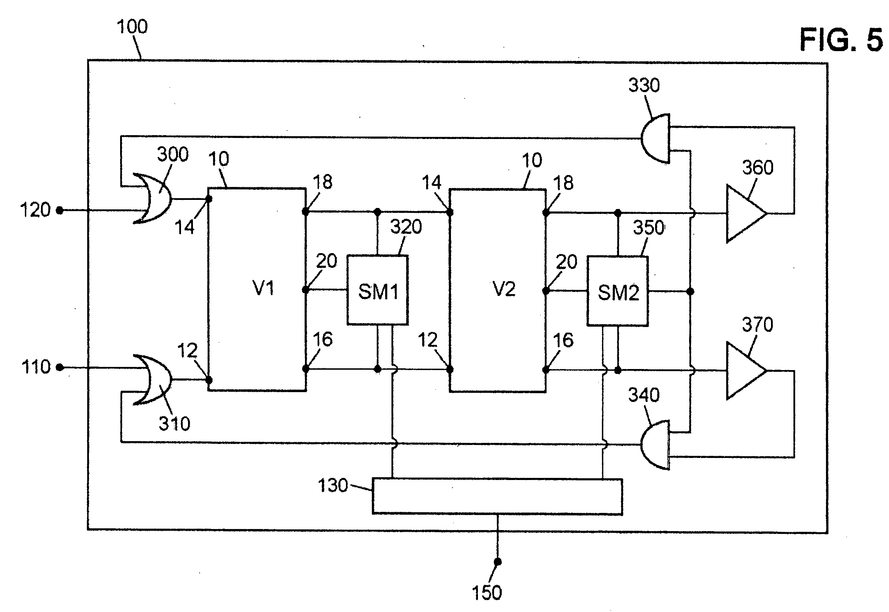

In the example in figure 5, the converter 100 is represented in a third alternative embodiment, comprising a first vernier delay unit V1, a second vernier delay unit V2, a first "OR" logic gate 300, a second "OR" logic gate 310, a first state machine 320, a second state machine 350, a first "AND" logic gate 330, a second "AND" logic gate 340, a calculation means 130, a first timer 360, and a second timer 370. The "OR" logic gates 300 and 310 are each designed to perform a non-exclusive OR Boolean operation on received input signals in order to obtain an output signal. The "AND" logic gates 330 and 340 are each designed to perform an AND Boolean operation on received input signals in order to obtain an output signal. The inputs to the first "OR" logic gate 300 are connected to receive the output signal from the first "AND" logic gate 330 and the reference signal $S_{ref}$. The output signal from the first "OR" logic gate 300 is connected to the second input 14 of the first vernier delay unit V1. The inputs to the second "OR" logic gate 310 are connected to receive the output signal from the second "AND" logic gate 340 and the output signal $S_{out}$. The output signal from the second "OR" logic gate 310 is connected to the first input 12 of the first vernier delay unit V1.

The first state machine 320 comprises an input for receiving the word W1 delivered by the first vernier delay unit V1, and inputs for receiving the output signal $S_{out}$ and the reference signal $S_{ref}$ output from the first vernier delay unit V1. The second state machine 350 comprises an input for receiving the word W2 delivered by the second vernier delay unit V2, and inputs for receiving the output signal $S_{out}$ and the reference signal $S_{ref}$ output from the second vernier delay unit V2. The second state machine 350 has the particular function of allowing or not allowing the output signals from the second vernier delay unit V2 to loop to the inputs of the first vernier delay unit V1. To do this, the second state machine 350 comprises an output for delivering a control signal. The control signal initially has a value of 0. The second state machine 350 is programmed so that the control signal assumes a value of 1 upon detection of the rising or falling edge of the output signal $S_{out}$ from the second vernier delay unit V2. Alternatively, the second state machine 350 can be programmed so that the control signal assumes a value of 1 upon detection of the rising or falling edge of the output signal from the second vernier delay unit V2 which has undergone a timer delay in the first and second vernier delay unit V1 ,V2 of the smallest total duration. The state machine 220 also has the function of sending to the calculation means 130 the words W successively delivered over time by the second vernier delay unit V2.

The inputs to the first "AND" logic gate 330 are connected to receive the output signal from the second state machine 350, and to receive the output signal $S_{out}$ from the second vernier delay unit V1 delayed by a duration $\tau_3$ by the first timer 360. The inputs to the second "AND" logic gate 240 are connected to receive the output signal from the second state machine 350, and to receive the reference signal $S_{ref}$ output from the second vernier delay unit V2 delayed by a duration $\tau_4$ by the second timer 370. In particular, the duration $\tau_3$ and the duration $\tau_4$ are chosen so that the difference $\tau_3$-$\tau_4$ is substantially proportional to $\tau_1$ -$\tau_2$.

As is represented in figure 6, the converter 100 can in particular be used in a digital phase-locked loop, more commonly referred to as a digital PLL. The digital PLL receives the reference signal $S_{ref}$ of frequency $F_{ref}$ and delivers the output signal $S_{out}$ of frequency $F_{out}$. The digital PLL comprises a digital control unit 510, receiving as input a set point signal comprising:

- a number $N_{cycle}$ representing the number of complete cycles that $S_{out}$ must comprise for a period of the signal $S_{ref}$,
- a number $f_{cycle}$ representing a fraction of a complete cycle.

Thus the frequency $F_{out}$ is equal to ($N_{cycle}+f_{cycle}$) x $F_{ref}$.

The digital control unit 510 delivers a control signal to a digitally controlled oscillator 520 such that said oscillator generates the output signal $S_{out}$ as a function of $N_{cycle}$ and of $f_{cycle}$. A counter 530 is connected to the output of the oscillator, which counts the number $N'_{cycle}$ of cycles actually contained in the output signal $S_{out}$ for a period of the signal $S_{ref}$. The counter 530 is also connected to the digital control unit 510 in order to send the number $N'_{cycle}$ to said unit. The first input 110 of the converter 100 is connected to receive the output signal $S_{out}$. The second input 120 of the converter 100 is connected to receive the reference signal $S_{ref}$. The fractional part b which is output from the converter 100 is equivalent to the number $f'_{cycle}$ representing the fraction of a complete cycle actually contained in the output signal $S_{out}$. The output 150 from the converter is connected to the input of the digital control unit 510. Based on its knowledge of the number $f'_{cycle}$ and the number $N'_{cycle}$, the digital control unit 510 adapts the control signal to reduce the differences between the pair $N_{cycle}$, $f_{cycle}$ and the pair $N'_{cycle}$, $f'_{cycle}$.

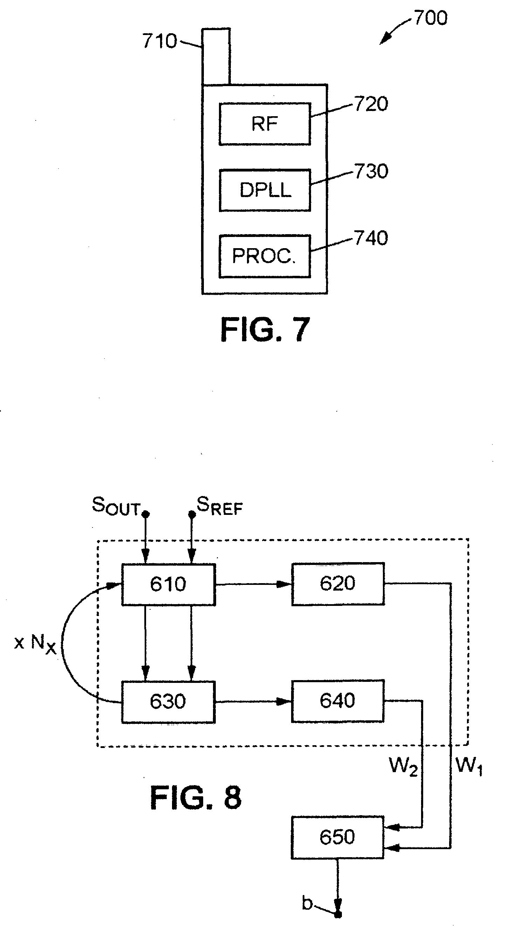

A digital phase-locked loop can, for example, be used in electronic equipment requiring the generation of electrical signals of a frequency that can be precisely configured. A radio communication transmitter/receiver 700 as illustrated in figure 7 is one example. Such a device 700 generally comprises an antenna 710, a radiofrequency processing means 720 coupled to a digital phase-locked loop 730, and a processing means 740 comprising a processor and memory. The digital PLL 730 is then used to modulate/demodulate the digital signals processed by the radiofrequency processing means 720.

Figure 8 illustrates the main steps according to an embodiment of a time-to-digital conversion process for determining a fractional part b of the number of periods of an output signal $S_{out}$ for a period of a reference signal $S_{ref}$. The process comprises a first step 610 in which the reference signal $S_{ref}$ is delayed relative to the output signal $S_{out}$. A first value W1, a function of the fractional part b, is determined in a second step 620. The output signal $S_{out}$ is then delayed relative to the reference signal $S_{ref}$, in a third step 630. At the end of the third step 630, a second value W2, a function of the fractional part b, is determined in a fourth step 640. The sequence comprising the first step 610, the second step 620, the third step 630, and the fourth step 640, can be repeated a whole number $N_x$ of times so as to obtain a greater number of first values W1 and second values W2. Then in a fifth step, the fractional part b is determined as a function of the first and second values W1 and W2 obtained.

## Claims

1. A time-to-digital conversion process for determining a digital information item corresponding to the fractional part (b) of the number of periods of a first signal ($S_{out}$) contained within a period of a second signal ($S_{ref}$), wherein it comprises the following steps:

   /1/ delaying the second signal ($S_{ref}$) by a first duration ($\tau_1$),
   /2/ delaying the first signal ($S_{out}$) by a second duration ($\tau_2$), with first duration ($\tau_1$) being greater than second duration ($\tau_2$),
   /3/ determining a first digital information item (W) comprising binary values indicating values of the delayed first signal after each rising edge among rising edges detected in the delayed second signal, **characterized in that** the process further comprises:
   /4/ repeating steps /1/, /2/, /3/ at least once with first duration ($\tau_1$) being less than second duration ($\tau_2$) to determine a second digital information item (W) comprising binary values indicating values of the delayed first signal after each rising edge among rising edges detected in the delayed second signal;

/5/ calculating the digital information item corresponding to the fractional part (b) as a function of the first and second digital information items (W).

2.  A computer program comprising instructions for implementing the process according to claim 1 when said program is executed by a processor.

3.  A time-to-digital conversion device comprising first connection means (110, 120) for receiving a first signal ($S_{out}$) and a second signal ($S_{ref}$), as well as an output (150) for delivering a digital information item corresponding to a fractional part (b) of the number of periods of the first signal ($S_{out}$) contained within a period of the second signal ($S_{ref}$), wherein it additionally comprises timing and comparison means comprising a first vernier delay unit comprising a first delay line for delaying the second signal ($S_{ref}$) and a second delay line for delaying the first signal ($S_{out}$), a first duration ($\tau_1$) introduced by the first delay line being greater than a second duration ($\tau_2$) introduced by the second delay line, said first vernier delay unit further comprising latches (D) adapted to sample the first signal ($S_{out}$) in order to obtain a first digital information item (W) comprising binary values indicating values of the delayed first signal after each rising edge among rising edges detected in the delayed second signal; **characterized in that** the device further comprises:

  a second vernier delay unit comprising a second vernier delay line comprising a first delay line for delaying the second signal ($S_{ref}$) and a second delay line for delaying the first signal ($S_{out}$), a first duration ($\tau_1$) introduced by the first delay line being less than a second duration ($\tau_2$) introduced by the second delay line, said first vernier delay unit further comprising latches (D) adapted to sample the first signal ($S_{out}$) in order to obtain a second digital information item (W) comprising binary values indicating values of the delayed first signal after each rising edge among rising edges detected in the delayed second signal;

  a calculation means connected to an output of each vernier delay unit and to determine the digital information item corresponding to the fractional part (b),

  based on the first and second digital information items (W)

  wherein said first vernier delay unit and second vernier unit being serially connected.

4.  A device according to claim 3, wherein the device comprise a first vernier delay unit (10) and a second vernier delay unit (10), serially connected, with said device comprising switching and timing means (300, 310, 320, 330, 340, 350, 360, 370) adapted to direct:

  • the second signal ($S_{ref}$), delayed by a third duration ($\tau_3$), to the first delay line (22) of the first vernier delay unit, and
  • the first signal ($S_{out}$), delayed by a fourth duration ($\tau_4$), to the second delay line (24) of the first vernier delay unit.

5.  A digital phase-locked loop, adapted to deliver a first signal ($S_{out}$) of a frequency ($F_{out}$) controlled by a set point signal, said digital phase-locked loop comprising a time-to-digital conversion device (100) according to any of claims 3 and 4 in order to determine a fraction of the number of cycles ($f'_{cycle}$) of the first signal ($S_{out}$) contained within a period of a second signal ($S_{ref}$).

6.  An electronic portable device comprising a digital phase-locked loop according to claim 5.

**Patentansprüche**

1.  Zeit-Digital-Wandlungsprozess zum Bestimmen eines digitalen Informationselements, entsprechend dem Bruchteil (b) der Zahl der Perioden eines ersten Signals ($S_{out}$), enthalten in einer Periode eines zweiten Signals ($S_{ref}$), wobei er die folgenden Schritte umfasst:

  /1/ Verzögern des zweiten Signals ($S_{ref}$) um eine erste Dauer ($T_1$),
  /2/ Verzögern des ersten Signals ($S_{out}$) um eine zweite Dauer ($\tau_2$), wobei die erste Dauer ($\tau_1$) länger als die zweite Dauer ($\tau_2$) ist,
  /3/ Bestimmen eines ersten digitalen Informationselements (W), umfassend Binärwerte, die Werte des verzögerten ersten Signals nach jeder steigenden Flanke unter in dem verzögerten zweiten Signal erkannten steigenden Flanken angeben, **dadurch gekennzeichnet, dass** der Prozess ferner umfasst:
  /4/ Wiederholen der Schritte /1/, /2/ /3/ mindestens einmal, wobei die erste Dauer ($\tau_1$) kürzer als die zweite Dauer ($\tau_2$) ist, zum Bestimmen eines zweiten digitalen Informationselements (W), umfassend Binärwerte, die Werte des verzögerten ersten Signals nach jeder steigenden Flanke unter in dem verzögerten zweiten Signal erkannten steigenden Flanken angeben;
  /5/ Berechnen des digitalen Informationselements, entsprechend dem Bruchteil (b), in Abhängigkeit von dem ersten und dem zweiten digitalen Informationselement (W).

**2.** Computerprogramm, umfassend Befehle zum Implementieren des Prozesses nach Anspruch 1, wenn das Programm durch einen Prozessor ausgeführt wird.

**3.** Zeit-Digital-Wandlungsvorrichtung, umfassend erste Verbindungsmittel (110, 120) zum Empfangen eines ersten Signals ($S_{out}$) und eines zweiten Signals ($S_{ref}$) sowie einen Ausgang (150) zum Liefern eines digitalen Informationselements, entsprechend einem Bruchteil (b) der Zahl der Perioden des ersten Signals ($S_{out}$), enthalten in einer Periode des zweiten Signals ($S_{ref}$), wobei sie zusätzlich Zeitsteuerungs- und Vergleichsmittel, umfassend eine erste Feineinstellverzögerungseinheit, umfassend eine erste Verzögerungsleitung zum Verzögern des zweiten Signals ($S_{ref}$) und eine zweite Verzögerungsleitung zum Verzögern des ersten Signals ($S_{out}$), umfasst, wobei eine erste, durch die erste Verzögerungsleitung eingeführte Dauer ($\tau_1$) länger als eine zweite, durch die zweite Verzögerungsleitung eingeführte Dauer ($\tau_2$) ist, wobei die erste Feineinstellverzögerungseinheit ferner Latches (D) umfasst, die so angepasst sind, dass sie das erste Signal ($S_{out}$) abtasten, um ein erstes digitales Informationselement (W), umfassend Binärwerte, die Werte des verzögerten ersten Signals nach jeder steigenden Flanke unter in dem verzögerten zweiten Signal erkannten steigenden Flanken angeben, zu erhalten;
**dadurch gekennzeichnet, dass** die Vorrichtung ferner umfasst:

eine zweite Feineinstellverzögerungseinheit, umfassend eine zweite Feineinstellverzögerungsleitung, umfassend eine erste Verzögerungsleitung zum Verzögern des zweiten Signals ($S_{ref}$) und eine zweite Verzögerungsleitung zum Verzögern des ersten Signals ($S_{out}$), wobei eine erste, durch die erste Verzögerungsleitung eingeführte Dauer ($\tau_1$) kürzer als eine zweite, durch die zweite Verzögerungsleitung eingeführte Dauer ($\tau_2$) ist, wobei die erste Feineinstellverzögerungseinheit ferner Latches (D) umfasst, die so angepasst sind, dass sie das erste Signal ($S_{out}$) abtasten, um ein zweites digitales Informationselement (W), umfassend Binärwerte, die Werte des verzögerten ersten Signals nach jeder steigenden Flanke unter in dem verzögerten zweiten Signal erkannten steigenden Flanken angeben, zu erhalten;
ein Berechnungsmittel, verbunden mit einem Ausgang jeder Feineinstellverzögerungseinheit, zum Bestimmen des digitalen Informationselements, entsprechend dem Bruchteil (b), auf der Grundlage des ersten und des zweiten digitalen Informationselements (W),
wobei die erste Feineinstellverzögerungseinheit und die zweite Feineinstelleinheit in Reihe geschaltet sind.

**4.** Vorrichtung nach Anspruch 3, wobei die Vorrichtung eine erste Feineinstellverzögerungseinheit (10) und eine zweite Feineinstellverzögerungseinheit (10) umfasst, die in Reihe geschaltet sind, wobei die Vorrichtung Schalt- und Zeitsteuerungsmittel (300, 310, 320, 330, 340, 350, 360, 370) umfasst, die so angepasst sind, dass sie lenken:

• das zweite Signal ($S_{ref}$), verzögert um eine dritte Dauer ($\tau_3$), zu der ersten Verzögerungsleitung (22) der ersten Feineinstellverzögerungseinheit, und
• das erste Signal ($S_{out}$), verzögert um eine vierte Dauer ($\tau_4$), zu der zweiten Verzögerungsleitung (24) der ersten Feineinstellverzögerungseinheit.

**5.** Digitaler Phasenregelkreis, der so angepasst ist, dass er ein erstes Signal ($S_{out}$) einer Frequenz ($F_{out}$), geregelt durch ein Sollwertsignal, liefert, wobei der digitale Phasenregelkreis eine Zeit-Digital-Wandlungsvorrichtung (100) nach einem der Ansprüche 3 und 4 umfasst, um einen Bruchteil der Zahl der Perioden ($f'_{cycle}$) des ersten Signals ($S_{out}$), enthalten in einer Periode eines zweiten Signals ($S_{ref}$), zu bestimmen.

**6.** Elektronisches tragbares Gerät, umfassend einen digitalen Phasenregelkreis nach Anspruch 5.

**Revendications**

**1.** Procédé de conversion temps-numérique permettant de déterminer un élément d'information numérique correspondant à la partie fractionnaire (b) du nombre de périodes d'un premier signal ($S_{out}$) contenu dans une période d'un second signal ($S_{ref}$), dans lequel il comprend les étapes suivantes :

/1/ le retardement du second signal ($S_{ref}$) par une première durée ($\tau_1$),
/2/ le retardement du premier signal ($S_{out}$) par une deuxième durée ($\tau_2$), la première durée ($\tau_1$) étant supérieure à la deuxième durée ($\tau_2$),
/3/ la détermination d'un premier élément d'information numérique (W) comprenant des valeurs binaires indiquant des valeurs du premier signal retardé après chaque front montant parmi des fronts montants détectés dans le second signal retardé, **caractérisé en ce que** le procédé comprend en outre :
/4/ la répétition des étapes /1/, /2/, /3/ au moins une fois avec la première durée ($\tau_1$) inférieure à la deuxième durée ($\tau_2$) pour déterminer un second élément d'information numérique (W) comprenant des valeurs binaires indiquant des valeurs du premier signal retardé après chaque front montant parmi des fronts montants détectés dans le second signal retardé ;

/5/ le calcul de l'élément d'information numérique correspondant à la partie fractionnaire (b) en fonction des premier et second éléments d'information numérique (W).

2. Programme informatique comprenant des instructions permettant d'implémenter le procédé selon la revendication 1 lorsque ledit programme est exécuté par un processeur.

3. Dispositif de conversion temps-numérique comprenant des premiers moyens de connexion (110, 120) permettant de recevoir un premier signal ($S_{out}$) et un second signal ($S_{ref}$), ainsi qu'une sortie (150) permettant de délivrer un élément d'information numérique correspondant à une partie fractionnaire (b) du nombre de périodes du premier signal ($S_{out}$) contenu dans une période du second signal ($S_{ref}$), dans lequel il comprend en outre des moyens de synchronisation et de comparaison comprenant une première unité de retard par vernier comprenant une première ligne de retard permettant de retarder le second signal ($S_{ref}$) et une seconde ligne de retard permettant de retarder le premier signal ($S_{out}$), une première durée ($\tau_1$) introduite par la première ligne de retard étant supérieure à une deuxième durée ($\tau_2$) introduite par la seconde ligne de retard, ladite première unité de retard par vernier comprenant en outre des verrous (D) adaptés pour échantillonner le premier signal ($S_{out}$) afin d'obtenir un premier élément d'information numérique (W) comprenant des valeurs binaires indiquant des valeurs du premier signal retardé après chaque front montant parmi les fronts montants détectés dans le second signal retardé ;

**caractérisé en ce que** le dispositif comprend en outre :

une seconde unité de retard par vernier comprenant une seconde ligne de retard par vernier comprenant une première ligne de retard permettant de retarder le second signal ($S_{ref}$) et une seconde ligne de retard permettant de retarder le premier signal ($S_{out}$), une première durée ($\tau_1$) introduite par la première ligne de retard étant inférieure à une deuxième durée ($\tau_2$) introduite par la seconde ligne de retard, ladite première unité de retard par vernier comprenant en outre des verrous (D) adaptés pour échantillonner le premier signal ($S_{out}$) afin d'obtenir un second élément d'information numérique (W) comprenant des valeurs binaires indiquant des valeurs du premier signal retardé après chaque front montant parmi des fronts montants détectés dans le second signal retardé ;

un moyen de calcul connecté à une sortie de chaque unité de retard par vernier et pour déterminer l'élément d'information numérique correspondant à la partie fractionnaire (b), en fonction des premier et second éléments d'information numérique (W),

dans lequel ladite première unité de retard par vernier et ladite seconde unité de retard par vernier sont connectées en série.

4. Dispositif selon la revendication 3, dans lequel le dispositif comprend une première unité de retard par vernier (10) et une seconde unité de retard par vernier (10), connectées en série, ledit dispositif comprenant des moyens de commutation et de synchronisation (300, 310, 320, 330, 340, 350, 360, 370) adaptés pour diriger :

- le second signal ($S_{ref}$), retardé par une troisième durée ($\tau_3$), vers la première ligne de retard (22) de la première unité de retard par vernier, et
- le premier signal ($S_{out}$), retardé par une quatrième durée ($\tau_4$), vers la seconde ligne de retard (24) de la première unité de retard par vernier.

5. Boucle de phase bloquée numérique, adaptée pour délivrer un premier signal ($S_{out}$) d'une fréquence ($F_{out}$) commandée par un signal de point de consigne, ladite boucle de phase bloquée numérique comprenant un dispositif de conversion temps-numérique (100) selon l'une quelconque des revendications 3 et 4 afin de déterminer une fraction du nombre de cycles ($f_{cycle}$) du premier signal ($S_{out}$) contenu dans une période d'un second signal ($S_{ref}$).

6. Dispositif portable électronique comprenant une boucle de phase bloquée numérique selon la revendication 5.

**FIG. 1**

EP 2 499 741 B1

EP 2 499 741 B1

$T_2$

$F_2$

$T_1$

$b.T_1$

$F_1$

$a.T_1$

**FIG. 2**

10  10  10  100

110

120

V1  V2  V3

$W_1$  $W_2$  $W_3$  130

**FIG. 3**

b  150

FIG. 4

FIG. 6

FIG. 5

EP 2 499 741 B1

710

720

RF

730

DPLL

740

PROC.

700

## FIG. 7

$S_{OUT}$    $S_{REF}$

$\times N_X$

610    620

630    640

$W_2$    $W_1$

650

b

## FIG. 8

**EP 2 499 741 B1**

**REFERENCES CITED IN THE DESCRIPTION**

**Patent documents cited in the description**

- US 2008012549 A
- US 5229668 A
- US 2009028274 A
- US 6108794 A